(19) Europäisches Patentamt
European Patent Office
Office européen des brevets

(11) EP 2 065 430 A1

(12) EUROPEAN PATENT APPLICATION

(43) Date of publication:
**03.06.2009 Bulletin 2009/23**

(21) Application number: **08020391.2**

(22) Date of filing: **24.11.2008**

(51) Int Cl.:
***C08G 77/58*** *(2006.01)* ***H01L 23/29*** *(2006.01)*
***H01L 33/00*** *(2006.01)*

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **28.11.2007 JP 2007306818**

(71) Applicant: **Nitto Denko Corporation**
**Ibaraki-shi,**
**Osaka 567-8680 (JP)**

(72) Inventor: **Katayama, Hiroyuki**
**Ibaraki-shi**
**Osaka 567-8680 (JP)**

(74) Representative: **Grünecker, Kinkeldey,**
**Stockmair & Schwanhäusser**
**Anwaltssozietät**
**Leopoldstrasse 4**
**80802 München (DE)**

# (54) Resin for optical-semiconductor-element encapsulation containing polyaluminosiloxane and optical semiconductor device obtained with the same

(57) The present invention relates to a resin for optical-semiconductor-element encapsulation which comprises a polyaluminosiloxane obtained by reacting a silicon compound with an aluminum compound, and an optical semiconductor device obtained with the resin. The resin has satisfactory light-transmitting properties and low hygroscopicity and suffers no discoloration when used at a high temperature.

EP 2 065 430 A1

## Description

### FIELD OF THE INVENTION

The present invention relates to a resin for optical-semiconductor-element encapsulation and an optical semiconductor device obtained with the resin.

### BACKGROUND OF THE INVENTION

Resin compositions for optical-semiconductor-element encapsulation, which are used for encapsulating optical semiconductor elements such as light-emitting diodes (LEDs), are required to give a cured resin having transparency. In general, epoxy resin compositions obtained from an epoxy resin, such as a bisphenol A epoxy resin or an alicyclic epoxy resin, and an acid anhydride hardener have been commonly used (see, for example, JP-A-2006-274249).

However, since epoxy resins have high hygroscopicity, there are cases where the encapsulating material cracks when the optical semiconductor device is mounted by reflow soldering. In addition, there are cases where the epoxy resins discolor when used over long at high temperatures, resulting in a decrease in luminance of the light-emitting diode devices.

### SUMMARY OF THE INVENTION

An object of the invention is to provide a resin for optical-semiconductor-element encapsulation which has satisfactory light-transmitting properties and low hygroscopicity and suffers no discoloration when used at a high temperature. Another object of the invention is to provide an optical semiconductor device which includes an optical semiconductor element encapsulated with the resin and has a satisfactory luminance retention.

Namely, the invention provides the following items 1 to 7.

1. A resin for optical-semiconductor-element encapsulation which comprises a polyaluminosiloxane obtained by reacting a silicon compound with an aluminum compound.
2. The resin for optical-semiconductor-element encapsulation according to item 1, wherein the silicon compound is at least one of:

a compound represented by the following formula (I):

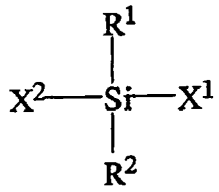

(I)

wherein $R^1$ and $R^2$ each independently represent an alkyl group, a cycloalkyl group, an alkenyl group, an alkynyl group, or an aryl group; and $X^1$ and $X^2$ each independently represent an alkoxy group, a hydroxy group, or a halogen; and
a compound represented by the following formula (II):

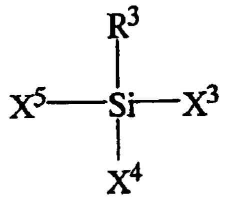

(II)

wherein $R^3$ represents an alkyl group, a cycloalkyl group, an alkenyl group, an alkynyl group, or an aryl group; and $X^3$, $X^4$, and $X^5$ each independently represent an alkoxy group, a hydroxy group, or a halogen.

3. The resin for optical-semiconductor-element encapsulation according to item 1, wherein the aluminum compound is represented by the following formula (III):

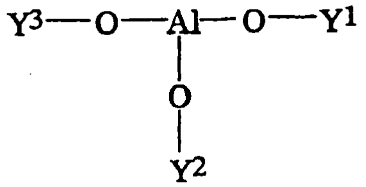

(III)

wherein $Y^1$, $Y^2$, and $Y^3$ each independently represent hydrogen or an alkyl group.
4. The resin for optical-semiconductor-element encapsulation according to item 2, wherein the silicon compound is at least one of dimethyldimethoxysilane and diphenyldimethoxysilane.
5. The resin for optical-semiconductor-element encapsulation according to item 3, wherein the aluminum compound is aluminum triisopropoxide.
6. An optical semiconductor device comprising an optical semiconductor element encapsulated with the resin according to item 1.
7. The optical semiconductor device according to item 6, which has a luminance retention of 70% or higher.

According to the present invention, it is possible to obtain a resin for optical-semiconductor-element encapsulation which has satisfactory light-transmitting properties and low hygroscopicity and suffers no discoloration when used at a high temperature. Furthermore, it is also possible to obtain an optical semiconductor device which includes an optical semiconductor element encapsulated with the resin and has a satisfactory luminance retention.
The resin for optical-semiconductor-element encapsulation of the invention is suitable for use in, e.g., backlights for liquid-crystal screens, traffic signals, large outdoor displays, and advertising signboards.

## DETAILED DESCRIPTION OF THE INVENTION

The resin for optical-semiconductor-element encapsulation of the invention contains a polyaluminosiloxane obtained by reacting a silicon compound with an aluminum compound.
Preferred examples of the silicon compound are compounds represented by the following formula (I):

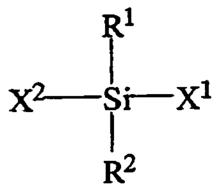

(I)

wherein $R^1$ and $R^2$ each independently represent an alkyl group, a cycloalkyl group, an alkenyl group, an alkynyl group, or an aryl group; and $X^1$ and $X^2$ each independently represent an alkoxy group, a hydroxy group, or a halogen.
In the formula (I), $R^1$ and $R^2$ each independently represent an alkyl group, cycloalkyl group, alkenyl group, alkynyl group, or aryl group. The number of carbon atoms of each of these groups is preferably 1-18, more preferably 1-12, and even more preferably 1-6, from the standpoints of reactivity, stability, and profitability. Examples thereof include alkyl groups such as methyl, ethyl, propyl, and isopropyl; cycloalkyl groups such as cyclopentyl and cyclohexyl; alkenyl groups such as vinyl and allyl; alkynyl groups such as ethynyl and propynyl; and aryl groups such as phenyl and tolyl. Preferred of these are alkyl groups and aryl groups. It is preferred that $R^1$ and $R^2$ each independently are methyl or phenyl.
In the formula (I), $X^1$ and $X^2$ each independently represent an alkoxy group, hydroxy group, or halogen. The number of carbon atoms of the alkoxy group is preferably 1-4, and more preferably 1-2. Examples thereof include methoxy and ethoxy. Methoxy is preferred of these. The halogen preferably is chlorine or bromine.
Examples of the silicon compound represented by the formula (I) include diphenyldimethoxysilane, dimethyldimethoxysilane, diphenyldihydroxysilane, dimethyldiethoxysilane, diphenyldiethoxysilane, diethyldimethoxysilane, diethyldiethoxysilane, diisopropyldimethoxysilane, diisopropyldiethoxysilane, methylphenyldimethoxysilane, methylphenyldiethoxysilane, dimethyldichlorosilane, diphenyldichlorosilane, diethyldichlorosilane, diisopropyldichlorosilane, and

methylphenyldichlorosilane. Such compounds may be used alone or in combination of two or more thereof. Preferred of these are dimethyldimethoxysilane, in which $R^1$ and $R^2$ each are methyl and $X^1$ and $X^2$ each are methoxy; and diphenyldimethoxysilane, in which $R^1$ and $R^2$ each are phenyl and $X^1$ and $X^2$ each are methoxy.

Furthermore, other preferred examples of the silicon compound are compounds represented by the following formula (II):

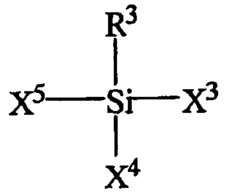

(II)

wherein $R^3$ represents an alkyl group, a cycloalkyl group, an alkenyl group, an alkynyl group, or an aryl group; and $X^3$, $X^4$, and $X^5$ each independently represent an alkoxy group, a hydroxy group, or a halogen.

In the formula (II), $R^3$ represents an alkyl group, cycloalkyl group, alkenyl group, alkynyl group, or aryl group. The number of carbon atoms of each of these groups is preferably 1-18, more preferably 1-12, and even more preferably 1-6, from the standpoints of reactivity, stability, and profitability. Examples thereof include the same groups as those enumerated above as examples of $R^1$ and $R^2$ in the formula (I). $R^3$ is preferably an alkyl group or aryl group, and more preferably methyl.

In the formula (II), $X^3$, $X^4$, and $X^5$ each independently represent an alkoxy group, a hydroxy group, or a halogen. The number of carbon atoms of the alkoxy group is preferably 1-4, and more preferably 1-2. Examples thereof include the same alkoxy groups as those enumerated above with regard to $X^1$ and $X^2$ in the formula (I). Preferred of these is methoxy. The halogen preferably is chlorine or bromine.

Examples of the silicon compound represented by formula (II) include phenyltrimethoxysilane, methyltrimethoxysilane, methyltrichlorosilane, phenyltrichlorosilane, phenyltriethoxysilane, methyltriethoxysilane, ethyltrimethoxysilane, ethyltrichlorosilane, isopropyltrimethoxysilane, and isopropyltrichlorosilane. Such compounds may be used alone or in combination of two or more thereof. Preferred of these is methyltrimethoxysilane, in which $R^3$ is methyl and $X^3$, $X^4$, and $X^5$ each are methoxy.

In preparing the encapsulating resin of the invention, one or more silicon compounds other than the silicon compound represented by the formula (I) and the silicon compound represented by the formula (II) may also be used so long as this does not lessen the effects of the invention. However, from the standpoints of heat resistance, transparency, and light resistance, the total amount of the silicon compound represented by the formula (I) and/or the silicon compound represented by the formula (II) to be used is preferably 30-95% by weight, more preferably 50-95% by weight, and even more preferably 60-95% by weight, of the mixture to be subjected to the reaction.

In the case where the silicon compound represented the formula (I) is used in combination with the silicon compound represented by the formula (II), the weight ratio therebetween {(silicon compound represented by the formula (I))/(silicon compound represented by the formula (II))} is preferably from 20/1 to 1/10 from the standpoint of the heat resistance and flexibility of the reaction product.

In $R^1$ and $R^2$ in the formula (I) and $R^3$ in the formula (II), the molar ratio between alkyl group and aryl group (alkyl group/aryl group) is preferably from 100/0 to 5/95, and more preferably from 100/0 to 15/85, from the standpoints of heat resistance, light resistance, and transparency.

The aluminum compound preferably is a compound represented by the following formula (III):

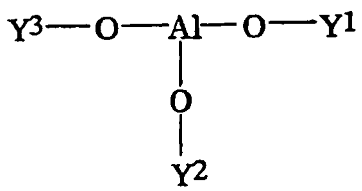

(III)

wherein $Y^1$, $Y^2$, and $Y^3$ each independently represent hydrogen or an alkyl group.

The number of carbon atoms of the alkyl group in the formula (III) is preferably 1-12, more preferably 1-6, and even more preferably 1-3. Examples of the alkyl group include methyl, ethyl, propyl, and isopropyl. Preferred of these

are ethyl and isopropyl, and isopropyl is more preferred.

Examples of the aluminum compound represented by the formula (III) include aluminum methoxide, aluminum ethoxide, aluminum propoxide, and aluminum butoxide. Such compounds may be used alone or in combination of two or more thereof. Preferred of these is aluminum triisopropoxide.

The molar ratio between the silicon compound and the aluminum compound to be reacted (silicon compound/ aluminum compound) is preferably from 1,000/1 to 1/1, more preferably from 500/1 to 1/1, from the standpoints of heat resistance, transparency, and light resistance.

Substances other than the compounds described above may be used in the reaction so long as this does not lessen the effects of the invention. For example, hydrochloric acid may be used. The amount of hydrochloric acid (pH 2-6) to be used is preferably 5-30% by weight, more preferably 5-20% by weight, and even more preferably 5-15% by weight, of the mixture to be subjected to the reaction from the standpoint of improving reaction rate.

The reaction of the silicon compound with the aluminum compound can be conducted, for example, with stirring at a temperature of 0-100°C for 1-48 hours. Examples of methods usable in this case include a method in which the silicon compound is dissolved in a solvent such as toluene, THF, or an alcohol and the aluminum compound is added to the solution and reacted. However, usable methods should not be construed as being limited to that method. In the case where two or more silicon compounds are used, these compounds may be subjected to the reaction at a time. However, since the compounds can differ in reactivity due to their functional groups, the compounds can be subjected to the reaction separately from each other.

After the reaction of the silicon compound with the aluminum compound, the reaction mixture may be subjected, for example, to an evaporation treatment with an evaporator to remove volatile ingredients.

The resin for optical-semiconductor-element encapsulation thus obtained may be used to encapsulate an optical semiconductor element by applying the resin by spin coating or another technique and then drying the resin at preferably 50-300°C, more and preferably 50-250°C, for a period of preferably 1-48 hours, and more preferably 1-24 hours. The thickness of the resin after the encapsulation is preferably 50-5,000 μm, more preferably 100-4,000 μm, from the standpoint of protecting the optical semiconductor element.

The resin of the invention is suitable for use as a resin for encapsulating an optical semiconductor element for use in backlights for liquid-crystal screens, traffic signals, large outdoor displays, advertising signboards, etc.

The invention further relates to an optical semiconductor device including an optical semiconductor element encapsulated with the resin for optical-semiconductor-element encapsulation.

The optical semiconductor device of the invention has a luminance retention of preferably 70% or higher, and more preferably 90% or higher, from the standpoint of securing durability. In this regard, luminance retention can be defined by the following equation.

$$\text{luminance retention} = [(\text{luminance after 300-hour continuous lighting at 300 mA})/(\text{luminance just after test initiation})] \times 100$$

Luminance can be measured by the method described in the Examples which will be given below.

Examples

EXAMPLE 1

To a toluene solution (5 mL) of 4.82 g (40.2 mmol) of dimethyldimethoxysilane were added 0.410 g (2.01 mmol) of aluminum triisopropoxide and 1.3 mL of hydrochloric acid (pH 2). This mixture was stirred at 80°C for 2 hours and then treated with a rotary evaporator to remove volatile ingredients therefrom. Thus, a colorless, transparent, oily resin for optical-semiconductor-element encapsulation containing a polyaluminosiloxane was obtained (2.17 g; yield, 70%).

A substrate having a blue-light-emitting diode mounted thereon was prepared. The resin for optical-semiconductor-element encapsulation obtained was applied by spin coating to that surface of the substrate including the blue-light-emitting diode. The resin applied was dried at 150°C for 3 hours to encapsulate the blue-light-emitting diode. Thus, a blue-light-emitting diode device was obtained.

EXAMPLE 2

A blue-light-emitting diode device was obtained in the same manner as in Example 1, except that a resin for optical-semiconductor-element encapsulation was obtained in the following manner. To a toluene solution (5 mL) of 4.90

g (20.1 mmol) of diphenyldimethoxysilane and 2.41 g (20.1 mmol) of dimethyldimethoxysilane were added 0.410 g (2.01 mmol) of aluminum triisopropoxide and 1.3 mL of hydrochloric acid (pH 2). This mixture was stirred at 80°C for 2 hours, and volatile ingredients were removed therefrom to obtain a colorless, transparent, oily resin for optical-semiconductor-element encapsulation containing a polyaluminosiloxane (4.36 g; yield, 78%).

EXAMPLE 3

A blue-light-emitting diode device was obtained in the same manner as in Example 1, except that a resin for optical-semiconductor-element encapsulation was obtained in the following manner. To a toluene solution (5 mL) of 4.90 g (20.1 mmol) of diphenyldimethoxysilane and 2.41 g (20.1 mmol) of dimethyldimethoxysilane were added 0.164 g (0.804 mmol) of aluminum triisopropoxide and 1.5 mL of hydrochloric acid (pH 2). This mixture was stirred at 80°C for 2 hours, and volatile ingredients were removed therefrom to obtain a colorless, transparent, oily resin for optical-semiconductor-element encapsulation containing a polyaluminosiloxane (4.22 g; yield, 76%).

EXAMPLE 4

A blue-light-emitting diode device was obtained in the same manner as in Example 1, except that a resin for optical-semiconductor-element encapsulation was obtained in the following manner. To a toluene solution (5 mL) of 4.88 g (20.0 mmol) of diphenyldimethoxysilane, 1.80 g (15.0 mmol) of dimethyldimethoxysilane, and 0.681 g (5.01 mmol) of methyltrimethoxysilane were added 0.017 g (0.083 mmol) of aluminum triisopropoxide and 1.4 mL of hydrochloric acid (pH 2). This mixture was stirred at 80°C for 2 hours, and volatile ingredients were removed therefrom to obtain a colorless, transparent, oily resin for optical-semiconductor-element encapsulation containing a polyaluminosiloxane (4.30 g; yield, 76%).

COMPARATIVE EXAMPLE 1

Forty-five parts by weight of a bisphenol A epoxy resin having an epoxy equivalent of 7,500 (Epikote EP1256, manufactured by Japan Epoxy Resins Co., Ltd.), 33 parts by weight of an epoxy resin having an alicyclic framework and having an epoxy equivalent of 260 (EHPE-3150, manufactured by Daicel Chemical Industries, Ltd.), 22 parts by weight of 4-methylhexahydrophthalic anhydride (MH-700, manufactured by New Japan Chemical Co., Ltd.), and 1.2 parts by weight of 2-methylimidazole (2MZ, manufactured by Shikoku Chemicals Corp.) were dissolved in methyl ethyl ketone in such amounts as to result in a concentration of 50%. Thus, a coating solution was produced. This solution was applied to a polyester film in such an amount as to result in a thickness of 100 μm, and then dried at 130°C for 2 minutes. Three sheets of this epoxy resin coating were thermally laminated together at 100°C while suitably stripping off the polyester film to thereby produce an epoxy resin sheet having a thickness of 300 μm.

A substrate having a blue-light-emitting diode mounted thereon was heated to 150°C. Thereafter, the epoxy resin sheet obtained was placed on the substrate so that the blue-light-emitting diode was covered with the sheet. The blue-light-emitting diode was encapsulated at a pressure of 0.5 MPa to obtain a blue-light-emitting diode device.

The resins and devices obtained above were respectively examined according to the following evaluation items. The results obtained are shown in Table 1.

(Light Transmittance)

The resins obtained in the Examples and Comparative Example were examined with a spectrophotometer (U-4100, manufactured by Hitachi High-Technologies Corp.) for light transmittance (converted to a value corresponding to a resin thickness of 50 μm) at a wavelength of 450 nm.

(Heat Resistance)

The resins obtained in the Examples and Comparative Example were allowed to stand in a 150°C hot-air drying oven for 100 hours. The resins which had undergone the 100-hour standing were visually examined for transparency. The resins which suffered no color change from the original state are indicated by "good", and the resin which changed in color from the original state is indicated by "poor".

(Hygroscopicity)

With respect to each of the resins obtained in the Examples and Comparative Example, an increase in weight through 24-hour standing under the conditions of 60°C and 90% RH was calculated. Hygroscopicity is expressed in

terms of the value calculated with the equation: {[(weight of the resin after 24-hour standing)-(weight of the resin before standing)]/(weight of the resin before standing)} × 100.

(Luminance Retention)

A current of 300 mA was caused to flow through each of the blue-light-emitting diode devices obtained in the Examples and Comparative Example, and the luminance of the device immediately after initiation of the test was measured with an MCPD (momentary multi-channel photodetector system MCPD-3000, manufactured by Otsuka Electronics Co., Ltd.). Thereafter, each device was allowed to stand, with the current flowing therethrough. After 300 hours, the luminance of this device was measured in the same manner. The luminance retention was calculated using the following equation. The diode devices having a luminance retention of 70% or higher were judged to have satisfactory light resistance.
Luminance retention (%) = [(luminance after 300-hour continuous lighting at 300 mA)/(luminance just after test initiation)]× 100

Table 1

| | Example 1 | Example 2 | Example 3 | Example 4 | Comparative Example 1 |
|---|---|---|---|---|---|
| Light transmittance (%) | 100 | 100 | 100 | 100 | 95 |
| Heat resistance | good | good | good | good | poor |
| Hygroscopicity (%) | 0.2 | 0.1 | 0.1 | 0.1 | 0.3 |
| Luminance retention (%) | 100 | 99 | 100 | 99 | 40 |

It can be seen from the results given in Table 1 that the resins for optical-semiconductor-element encapsulation according to the invention have satisfactory light-transmitting properties and low hygroscopicity and suffer no discoloration when used at a high temperature. Furthermore, the optical semiconductor devices obtained by encapsulating an optical semiconductor element with these resins have a satisfactory luminance retention.
While the present invention has been described in detail and with reference to specific embodiments thereof, it will be apparent to one skilled in the art that various changes and modifications can be made therein without departing from the scope thereof.
This application is based on Japanese patent application No. 2007-306818 filed November 28, 2007, the entire contents thereof being hereby incorporated by reference.
Further, all references cited herein are incorporated in their entireties.

## Claims

1. A resin for optical-semiconductor-element encapsulation which comprises a polyaluminosiloxane obtained by reacting a silicon compound with an aluminum compound.

2. The resin for optical-semiconductor-element encapsulation according to claim 1, wherein the silicon compound is at least one of:

   a compound represented by the following formula (I):

   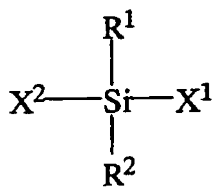

   (I)

   wherein $R^1$ and $R^2$ each independently represent an alkyl group, a cycloalkyl group, an alkenyl group, an alkynyl group, or an aryl group; and $X^1$ and $X^2$ each independently represent an alkoxy group, a hydroxy group, or a halogen; and

a compound represented by the following formula (II):

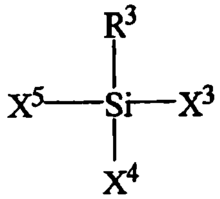

(II)

wherein $R^3$ represents an alkyl group, a cycloalkyl group, an alkenyl group, an alkynyl group, or an aryl group; and $X^3$, $X^4$, and $X^5$ each independently represent an alkoxy group, a hydroxy group, or a halogen.

3. The resin for optical-semiconductor-element encapsulation according to claim 1, wherein the aluminum compound is represented by the following formula (III):

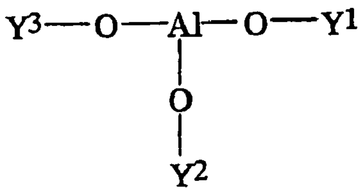

(III)

wherein $Y^1$, $Y^2$, and $Y^3$ each independently represent hydrogen or an alkyl group.

4. The resin for optical-semiconductor-element encapsulation according to claim 2, wherein the silicon compound is at least one of dimethyldimethoxysilane and diphenyldimethoxysilane.

5. The resin for optical-semiconductor-element encapsulation according to claim 3, wherein the aluminum compound is aluminum triisopropoxide.

6. An optical semiconductor device comprising an optical semiconductor element encapsulated with the resin according to claim 1.

7. The optical semiconductor device according to claim 6, which has a luminance retention of 70% or higher.

Europäisches Patentamt
European Patent Office
Office européen des brevets

# EUROPEAN SEARCH REPORT

Application Number
EP 08 02 0391

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 09 048787 A (SHINETSU CHEMICAL CO) 18 February 1997 (1997-02-18) * abstract * * paragraphs [0042], [0043] * ----- | 1,3,5 | INV. C08G77/58 H01L23/29 H01L33/00 |
| X<br>Y | EP 0 358 011 A (FRAUNHOFER GES FORSCHUNG [DE]) 14 March 1990 (1990-03-14) * page 3, lines 40-44 * * page 4, lines 17-25 * * page 6, lines 11-21; claims; examples * ----- | 1-5<br>6,7 | |
| X | EP 0 263 428 A (PPG INDUSTRIES INC [US]) 13 April 1988 (1988-04-13) * page 4, lines 8-24; claims 3-8; examples 2,7 * ----- | 1-3,5 | |
| X<br>Y | US 2003/216537 A1 (FRIEDRICH REINER [AU]) 20 November 2003 (2003-11-20) * paragraphs [0001], [0002], [0031] - [0035], [0049], [0051], [0080], [0081], [0090]; claims 1,14; examples 5,7 * ----- | 1-5<br>6,7 | TECHNICAL FIELDS SEARCHED (IPC) |
| X | EP 0 947 520 A (BAYER AG [DE] BAYER MATERIALSCIENCE AG [DE]) 6 October 1999 (1999-10-06) * paragraphs [0016], [0020]; claims; examples 11-14 * ----- | 1-3,5 | C08G H01L |
| X | DE 39 20 297 A1 (HENKEL KGAA [DE]) 17 January 1991 (1991-01-17) * page 3, lines 31-34; claims; examples 1,2 * ----- | 1,2,4 | |
| X | US 3 413 242 A (ROBERTS CHARLES B ET AL) 26 November 1968 (1968-11-26) * column 2, lines 46-48; claims; example 1 * ----- -/-- | 1 | |

The present search report has been drawn up for all claims

| Place of search | Date of completion of the search | Examiner |
|---|---|---|
| Munich | 11 March 2009 | Hein, Friedrich |

2

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 08 02 0391

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 1 684 363 A (SHINETSU CHEMICAL CO [JP]) 26 July 2006 (2006-07-26) * abstract; claims 1,7-9 * ----- | 6,7 | |

TECHNICAL FIELDS SEARCHED (IPC)

The present search report has been drawn up for all claims

2

| Place of search | Date of completion of the search | Examiner |
|---|---|---|
| Munich | 11 March 2009 | Hein, Friedrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 08 02 0391

This annex lists the patent family members relating to the patent documents cited in the above-mentioned European search report.
The members are as contained in the European Patent Office EDP file on
The European Patent Office is in no way liable for these particulars which are merely given for the purpose of information.

11-03-2009

| Patent document cited in search report | Publication date | Patent family member(s) | Publication date |
|---|---|---|---|
| JP 9048787 A | 18-02-1997 | NONE | |
| EP 0358011 A | 14-03-1990 | AT 132170 T | 15-01-1996 |
| | | DE 3828098 A1 | 08-03-1990 |
| | | ES 2084592 T3 | 16-05-1996 |
| | | GR 3018776 T3 | 30-04-1996 |
| | | JP 2160836 A | 20-06-1990 |
| EP 0263428 A | 13-04-1988 | AU 596702 B2 | 10-05-1990 |
| | | BR 8705242 A | 24-05-1988 |
| | | CN 87107834 A | 27-07-1988 |
| | | DE 3786864 D1 | 09-09-1993 |
| | | DE 3786864 T2 | 24-02-1994 |
| | | ES 2059338 T3 | 16-11-1994 |
| | | JP 6055925 B | 27-07-1994 |
| | | JP 63123838 A | 27-05-1988 |
| | | YU 182387 A1 | 28-02-1989 |
| US 2003216537 A1 | 20-11-2003 | WO 03097719 A1 | 27-11-2003 |
| | | AU 2003229352 A1 | 02-12-2003 |
| | | EP 1517944 A1 | 30-03-2005 |
| EP 0947520 A | 06-10-1999 | AT 268333 T | 15-06-2004 |
| | | CA 2267052 A1 | 30-09-1999 |
| | | DE 19814060 A1 | 07-10-1999 |
| | | ES 2222632 T3 | 01-02-2005 |
| | | JP 2000026610 A | 25-01-2000 |
| | | PT 947520 T | 29-10-2004 |
| | | US 6395826 B1 | 28-05-2002 |
| DE 3920297 A1 | 17-01-1991 | AU 5928690 A | 08-01-1991 |
| | | WO 9015852 A2 | 27-12-1990 |
| US 3413242 A | 26-11-1968 | NONE | |
| EP 1684363 A | 26-07-2006 | JP 2006202952 A | 03-08-2006 |
| | | KR 20060084808 A | 25-07-2006 |
| | | US 2006159937 A1 | 20-07-2006 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006274249 A
- JP 2007306818 A